# EUROPEAN PATENT APPLICATION

(11) **EP 1 596 419 A2**
(43) Date of publication of application: **16.11.2005**
(21) Application number: 05252884.1
(22) Date of filing: 11.05.2005
(51) Int. Cl.: H01J 37/32, C23C 16/44

(54) **High rate etching using fluorine plasma**

(30) Priority: 12.05.2004 US 570381 P; 12.08.2004 US 600851 P
(71) Applicant: THE BOC GROUP, INC., New Providence, NJ 07974-2082 (US)
(72) Inventor: McFarlane, Graham Anthony, Murrieta California 92563 (US); Hogle, Richard Allen, Oceanside California 92056 (US); Bailey, Christopher Mark, BOC Edwards, Unit 2, West Sussex BN43 6PB (GB)
(74) Representative: Booth, Andrew Steven

(57) **Abstract**

The present invention provides for the use of F2 in the process of deposition chamber cleaning which is especially effective if operated under high pressure conditions. In addition, the present invention provides for the use of F2 under high pressure to perform substrate etching or wafer thinning procedures at a high etch rate.

## Description

The present invention relates to methods of, and systems for, cleaning a deposition vacuum chamber and etching a substrate in a vacuum chamber.

Semiconductor products are generally produced by batch processing steps that use gases to deposit, or selectively etch, semiconductor layers on substrates within a vacuum chamber. Most of the chemical by-products and unused reagents from these deposition and etch processes are exhausted from the chamber by a vacuum pump. However, some residue unavoidably deposits and accumulates on the interior walls of the vacuum chamber. To ensure high device yield and quality, the residue must be periodically removed from the chamber. Usually the residue is removed using gas mixtures containing a fluorine-containing cleaning gas, the cleaning gas usually being diluted with argon or helium.

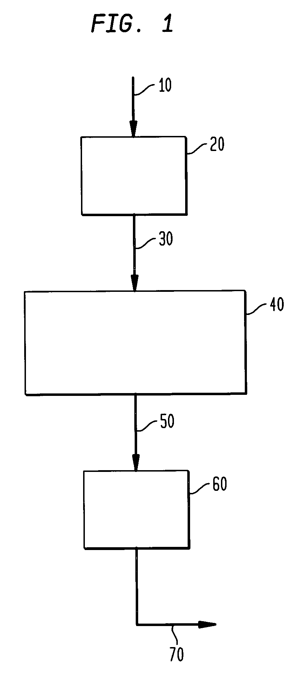

One known method of cleaning a vacuum deposition chamber is to utilize remote plasma source (RPS) technology operating with NF3 plasma. A standard RPS apparatus and method are shown in Figure 1, wherein a flow of NF3 and diluent gas 10, (Ar shown), enters an RPS 20, such as an MKS Instruments Astron® series that uses low-field-toroidal plasma technology to efficiently dissociate the NF3 input gas to produce atomic fluorine. The atomic fluorine 30 is transported to the vacuum chamber 40 where it chemically reacts with the unwanted residue on the interior walls of the vacuum chamber to form volatile compounds 50 that are removed from the chamber via the vacuum system, comprising a pump 60 and exhaust stream 70.

When using the apparatus shown in Figure 1, the plasma can be initially ignited with pure argon and then NF3 is added in a flow range from 1-10 slpm. The pressure is maintained constant, and the cleaning is conducted at a constant flow condition involving the NF3 flow plus various levels of Argon. Normally the argon flow rate is less than the NF3 flow rate.

One disadvantage of using NF3 is that the RPS system is normally operated at less than 5 Torr, and usually in the range of 0.5 to 3 Torr, although it has been suggested in the literature that up to 10 Torr pressure may be used. Therefore, etch rates for the commercial operations described above are limited to relatively low levels, as will be described in more detail below.

Further, NF3 is costly. Therefore, particularly in large deposition systems such as those used for 300mm wafer processing or flat panel display manufacturing, that require a high consumption of NF3, the cleaning process may contribute a significant proportion to the cost of the final device.

It is an aim of at least the preferred embodiment of the present invention to seek to solve these problems.

In a first aspect, the present invention provides a method for cleaning a deposition vacuum chamber, said method utilizing F2 plasma at a pressure greater than 20 Torr.

In a second aspect, the present invention provides a method for etching a substrate in a vacuum chamber, said method utilizing F2 plasma at a pressure greater than 20 Torr.

The present invention provides for the use of F2 in the process of deposition chamber cleaning which is especially effective if operated under high pressure conditions. F2 from electrolytic generators (such as BOC Edwards Generation-F series) is a low-cost alternative to NF3, especially for use in deposition chamber cleaning applications. In accordance with the present invention, very high etch rates can be accomplished by using F2 under high pressure, preferably in the range from 20 to 170 Torr.

Preferably, the method uses a diluent gas selected from the group comprising argon, nitrogen, helium and mixtures thereof. The inventors have found that by using F2 that is diluted with a high amount of argon, even higher etch rates can be achieved. The results of some tests are shown in Table 1 and Table 2 below.

It has been found that F2 has a much wider operating window than NF3 in a typical RPS system. For example, an MKS Astronex RPS has a specified limit of power draw of ~8 kW. This limit is reached when using NF3 at 6 slm and 17.5 Torr. In contrast, by using F2, this limit was not reached even operating at 18 slm and 100 Torr. In etch rate tests where stoichiometrically equivalent flow rates, similar system pressures and no Ar diluent were used, there was no statistically significant difference in the etch rates when using NF3 or F2. This is shown from the experimental data set forth in Table 1 below.

**Table 1 -**

| Etch Rate Comparison | | | |
|---|---|---|---|
| | **Etch Rate (nm/s)** | | |
| **Parameters** | **Mean** | **Std Deviation** | **N** |
| 3 slm F2, 1.8 Torr | 8.33 | 1.079 | 8 |
| 2 slm NF3, 1.8 Torr | 9.03 | 1.030 | 7 |
| 3 slm F2, 3 Torr | 10.55 | 1.176 | 8 |
| 2 slm NF3, 3 Torr | 12.06 | 5.290 | 8 |
| 3 slm F2, 10 Torr | 24.68 | 1.857 | 8 |
| 2 slm NF3, 10 Torr | 27.70 | 4.180 | 8 |

When chamber pressures were raised, the etch rate for both F2 and NF3 was higher, but the etch rate for F2 was significant higher than for NF3. In particular, when using NF3, a maximum etch rate of about 80 nm/sec was observed, whereas, by using F2 at pressures up to about 170 Torr, it is possible to achieve etch rates of more than 250 nm/sec.

In addition, the effect of using F2 at different argon dilution was tested. It was found that by increasing the argon content, higher etch rates are possible.
Table 2 below includes some of the experimental results.

**Table 2 -**

| Etch Rate Using F2 At Different Argon Dilutions | | | |
|---|---|---|---|
| **F2 Flow** **(slpm)** | **Ar Flow** **(slpm)** | **Chamber Pressure** **(Torr)** | **Etch Rate** **(nm/sec)** |
| 3 | 2 | 10 | 22.21 |
| 3 | 4 | 20 | 28.90 |
| 3 | 6 | 5 | 15.98 |
| 3 | 6 | 27.5 | 59.69 |
| 3 | 6 | 27.5 | 67.51 |
| 3 | 6 | 27.5 | 56.68 |
| 3 | 6 | 27.5 | 46.27 |
| 3 | 6 | 27.5 | 42.43 |
| 3 | 6 | 30 | 40.97 |
| 3 | 6 | 50 | 82.17 |
| 3 | 8 | 40 | 96.76 |
| 3 | 9 | 20 | 143.41 |
| 3 | 10 | 50 | 86.65 |
| 3 | 12 | 5 | 17.52 |
| 3 | 12 | 20 | 49.45 |
| 3 | 12 | 27.5 | 50.30 |
| 3 | 12 | 50 | 140.31 |
| 3 | 12 | 51 | 191.79 |
| 3 | 13.4 | 80 | 185.60 |
| 3 | 13.4 | 90 | 159.83 |
| 3 | 14 | 60 | 235.09 |
| 3 | 14 | 70 | 249.38 |
| 3 | 14 | 70 | 134.27 |
| 3 | 14 | 70 | 148.56 |
| 3 | 14 | 75 | 252.83 |
| 3 | 14 | 80 | 161.06 |
| 3 | 14 | 80 | 171.97 |
| 3 | 14 | 80 | 116.97 |
| 3 | 14 | 85 | 224.53 |
| 3 | 14 | 90 | 253.79 |
| 3 | 14 | 90 | 424.05 |
| 3 | 14 | 90 | 211.02 |
| 3 | 14 | 95 | 180.84 |
| 3 | 15 | 90 | 168.51 |
| 3 | 16 | 70 | 152.45 |
| 3 | 16 | 80 | 10.61 |
| 3 | 16 | 90 | 88.39 |
| 3 | 16 | 90 | 80.58 |
| 3 | 16 | 100 | 112.23 |
| 3 | 16 | 108 | 66.83 |
| 3 | 18 | 80 | 62.12 |
| 3 | 18 | 90 | 124.38 |
| 3 | 18 | 100 | 189.98 |
| 3 | 18 | 110 | 129.84 |
| 3 | 18 | 120 | 199.01 |
| 3 | 18 | 130 | 125.78 |
| 3 | 20 | 80 | 92.97 |
| 3 | 20 | 90 | 77.59 |
| 3 | 20 | 100 | 134.72 |
| 3 | 20 | 110 | 115.52 |
| 3 | 20 | 120 | 91.09 |
| 3 | 20 | 130 | 131.03 |
| 3 | 20 | 140 | 183.73 |
| 3 | 20 | 150 | 138.29 |
| 3 | 20 | 160 | 111.30 |
| 3 | 20 | 170 | 287.97 |
| 3 | 20 | 180 | 154.85 |

It was further found that F2 can maintain a plasma, if a proper sequence is followed, up to 170 Torr, and it appears that even higher pressures may be possible. The increased effectiveness of using F2 was shown by conducting tests on an interferometer. The time taken to remove 335 nanometers of material from a wafer was measured for three different conditions. First a standard process running at 2 slpm of NF3 with no argon dilution and at approximately 3 Torr produced an etch rate of about 11 nm/sec. Next a process running at 2 slpm of NF3 at increased pressure of 20 Torr and an argon flow of 6 slpm argon produced an etch rate of about 78 nm/sec.
Finally, much faster etch rates were found but running a process at 3 slpm of F2 at 170 Torr and argon flow of 20 slpm (e.g. about 13% F2 in argon), producing an etch rate of about 288 nm/sec.

While the above clearly shows the increased effectiveness of using F2 in deposition cleaning operations, the present invention further provides for a method of using F2 under high pressure to perform substrate etching or wafer thinning procedures at a high etch rate.

The method of introduction of the F2 to the etching chamber can be an important consideration. For example, the direct introduction of F2 to a heated chamber can cause damage to the chamber components because of the reactivity of the F2 gas. Therefore, in such circumstances it may be necessary to cool the chamber prior to the introduction of the F2, but this slows down processing time and adds to the overall cost of production.

One method of overcoming these problems is to carry out a process for thermally activating the F2 comprising the steps of: (a) reacting the F2 gas and preheated inert gas to form a gaseous mixture; and (b) passing the gaseous mixture to an etching chamber to carry out the desired etching. The reacting step can be carried out in a mixing chamber to create the gaseous mixture and then further in a reaction chamber to ensure adequate contact between F2 gas and the heated inert gas. The inert gas is preferably argon, but may be other gases, such as, nitrogen, helium, and mixtures thereof.

In a third aspect, the present invention provides a method of etching a substrate in a vacuum chamber; said method comprising the steps of providing an inert gas to a mixing area at a first flow rate; initiating a plasma using said inert gas; providing F2 gas at a first flow rate to said mixing area to create a mixed plasma; increasing the flow rate of said inert gas to a second flow rate; introducing said mixed plasma to said vacuum chamber; increasing the pressure of said vacuum chamber while maintaining said mixed plasma; increasing said flow rate of said F2 to as second flow rate while maintaining said flow rate of said inert gas at a rate between 3 and 10 times that of said second flow rate of said F2; and etching said substrate.

In a fourth aspect, the present invention provides a method of cleaning a deposition vacuum chamber; said method comprising the steps of providing an inert gas to a mixing area at a first flow rate; initiating a plasma using said inert gas; providing F2 gas at a first flow rate to said mixing area to create a mixed plasma; increasing the flow rate of said inert gas to a second flow rate; introducing said mixed plasma to said vacuum chamber; increasing the pressure of said vacuum chamber while maintaining said mixed plasma; increasing said flow rate of said F2 to a second flow rate while maintaining said flow rate of said inert gas at a rate between 3 and 10 times that of said second flow rate of said F2 and cleaning said vacuum chamber.

In a fifth aspect, the present invention provides a system for cleaning a deposition vacuum chamber, said system comprising a source of F2 gas; a source of an inert gas; and a mixing chamber connected to said source of F2 gas and to said source of inert gas for receiving the F2 gas and inert gas and outputting a gaseous mixture of said F2 gas and said inert gas to the vacuum chamber.

In a sixth aspect, the present invention provides a system for etching a substrate in a vacuum chamber, said system comprising a source of F2 gas; a source of an inert gas and a mixing chamber connected to said source of F2 gas and to said source of inert gas for receiving the F2 gas and inert gas and outputting a gaseous mixture of said F2 gas and said inert gas to the vacuum chamber.

A system for carrying out the above process may thus comprise; a mixing chamber capable of reacting the F2 gas and the preheated inert gas to form a gaseous mixture, and a reaction chamber in gaseous communication with the mixing chamber for ensuring adequate contact between the F2 gas and the heated inert gas, such system being in gaseous communication with a process chamber.

In operation, the preheated inert gas is typically fed into the mixing chamber via any inert gas feed tube containing a packed bed of thermally conductive material, e.g. a finely divided metal such as nickel, Hastelloy, stainless steel, and combinations thereof. Copper and aluminium alloys may also be used if there is no concern of contamination for the particular process. The inert gas feed tube may be fabricated from any suitable material capable of carrying the inert gas, for example, nickel, Hastelloy, stainless steel, and combinations thereof. The inert gas feed tube may have a diameter of 1/2 inch to about 2 inches, preferably about 1/2 inch to about 1 inch, and more preferably about 3/4 inch. The flow rate for the inert gas is preferably about 1 slpm to about 20 slpm, preferably about 1 slpm to about 10 slpm, and more preferably about 2 slpm to about 6 slpm. The inert gas feed tube may be surrounded by a heater that preheats the inert gas to the desired temperature, typically to a temperature about 400°C to about 650°C. The heater may be any suitable heater, for example, electrical resistance heaters, radiant heaters, gas fired combustion heaters, and any combinations thereof.

The F2 gas is introduced to the mixing chamber via a F2 inlet tube. The F2 inlet tube may be fabricated from any suitable material capable of delivering the F2 gas, for example, sapphire, dense aluminium oxide, nickel, Hastelloy, and combinations thereof. The F2 inlet tube preferably has a diameter of about 1/4 inch to about 3/4 inch, more preferably about 1/4 inch to about 1/2 inch. The flow rate for the F2 gas is preferably about 1 slpm to about 20 slpm, more preferably about 2 slpm to about 6 slpm.

The heated inert gas and F2 gas flow into the mixing chamber where they form a gaseous mixture. This mixed gas stream then flows to the reaction chamber that is preferably constructed of a highly inert material such as nickel, dense aluminium oxide, sapphire, aluminium fluoride, calcium fluoride, or combinations thereof. Preferably the reaction chamber is constructed of sapphire, which is a crystal aluminium oxide material that forms an aluminium fluoride passivation layer. It is preferable to use inert materials for the construction of the reaction chamber to avoid hazardous operation because of the reactivity of the F2. In one embodiment, a sapphire inner tube is sealed to the nickel outer tube that allows for the use of normal elastomer seals, such as Viton or Klarez seals, without risk of damage by the F2 gas. The reaction chamber is preferably sized to ensure adequate contact between the F2 gas and the heated inert gas, for example, the reaction chamber may have a diameter of about 1 inch to about 1 and 1/2 inches, preferably about 1/2 inch to about 1 inch.

The mixture of F2 and high temperature inert gas is then delivered through an outlet tube to the process chamber for use as a cleaning or etching agent. The outlet tube is preferably constructed from an inert material to avoid reaction with the thermally activated F2 gas. Suitable inert materials for the outlet tube include the same material used for constructing the reaction chamber, preferably sapphire inside a nickel tube.

Preferred features of the present invention will now be described, by way of example only, with reference to the accompanying drawings, in which:
Figure 1 is a schematic representation of a RFP cleaning apparatus known in the prior art;
Figure 2 is a schematic representation of a system for remote plasma clean of a deposition chamber;
Figure 3 is a schematic representation of a system for in-situ plasma clean of a deposition chamber; and
Figure 4 is a schematic representation of a system for high rate wafer etching.

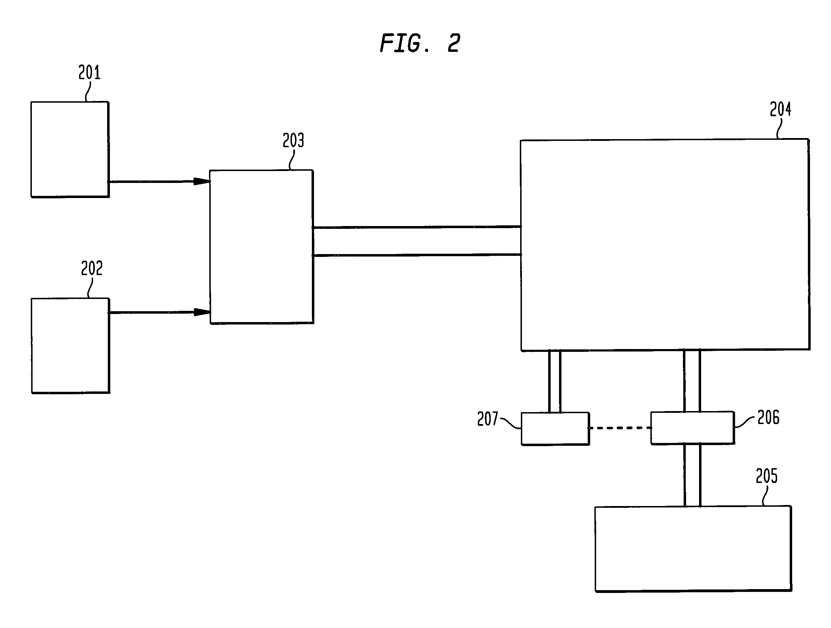

Figure 2 shows a flow scheme and sequence for remote plasma clean of a deposition chamber. Such cleaning may be carried out between runs for Si02, silicon nitride, tungsten, tungsten nitride, tungsten silicide and polysilicon or the like.

In greater detail, the system shown in Figure 2 includes an argon source 201, a F2 source 202, and an RPS 203, connected to the process chamber 204 that is controlled using a vacuum pump 205, valve 206 and pressure transducer 207. One method for operation of the system shown in Figure 2 is as follows:

Initially, the RPS 203 is set at approximately 0.5-3 Torr on transducer 207 which controls valve 206 on vacuum pump 205 with an argon flow of 1-2 slpm from argon source 201.

The plasma is then initiated by RPS 203 using pure argon.

F2 from F2 source 202 is then introduced and slowly ramped up from no flow at a rate no greater than 1 slpm increase per 5 seconds (i.e. ramping to 2 slpm should take at least 10 seconds). This helps the plasma stay lit while the fluorine is being added.

Argon flow rate is then increased to 10-20 slpm or between 3 times and 10 times the ultimate F2 flow for the particular process.

The pressure of the process chamber 204 is increased to between 30 and 300 Torr while maintaining plasma, using transducer 207 to control valve 206 on vacuum pump 205 during or after the ramp up of argon flow.

F2 flow is increased up to the full flow rate based on the size of the process chamber 204, e.g. from 2-200 slpm.

The argon flow is maintained at 3 to 10 times the F2 flow rate.

By using the above sequence, the process chamber 204 will be cleaned of surface deposits. At the end of the cycle, the F2 flow is turned off, then the plasma current on RPS 203 is turned off and finally, argon flow is turned down. The production process can then continue.

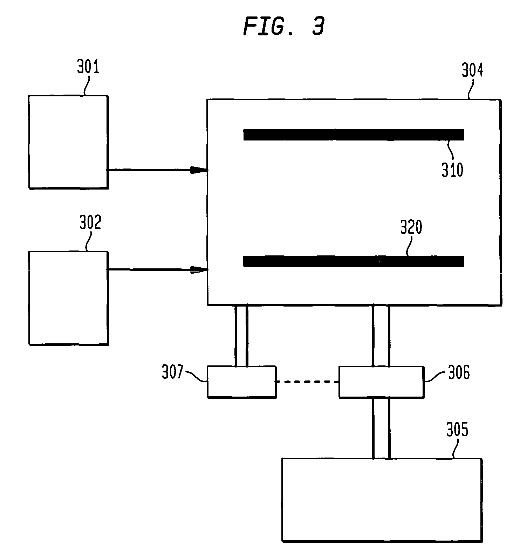

Figure 3 represents a system very similar to than shown in Figure 2. However, whereas Figure 2 describes a system using a remote plasma source, Figure 3 describes a system for in-situ cleaning. In particular, the system of Figure 3 includes an argon source 301, and a F2 source 302, connected to the process chamber 304 having electrodes 310 and 320, the process chamber being controlled using a vacuum pump 305, valve 306 and pressure transducer 307. One method for operation of the system shown in Figure 3 is as follows:

Initially, the process chamber 304 is set at approximately 0.5-3 Torr on transducer 307 which controls valve 306 on vacuum pump 305 with an argon flow of 1-2 slpm from argon source 301.

The plasma is then initiated by the electrodes 310 and 320 using pure argon.

F2 from F2 source 302 is then introduced and slowly ramped up from no flow at a rate no greater than 1 slpm increase per 5 seconds (i.e. ramping to 2 slpm should take at least 10 seconds). This helps the plasma stay lit while the fluorine is being added.

Argon flow rate is then increased to 10-20 slpm or between 3 times and 10 times the ultimate F2 flow for the particular process.

The pressure of process chamber 304 is increased to between 30 and 300 Torr while maintaining plasma, using transducer 307 to control valve 306 on vacuum pump 305 during or after the ramp up of argon flow.

F2 flow is increased up to the full flow rate based on the size of the process chamber 304, e.g. from 2-200 slpm.

The argon flow is maintained at 3 to 10 times the F2 flow rate.

By using the above sequence, the process chamber 304 will be cleaned of surface deposits. At the end of the cycle, the F2 flow is turned off, then the plasma current on electrodes 310 and 320 is turned off and finally, argon flow is turned down. The production process can then continue.

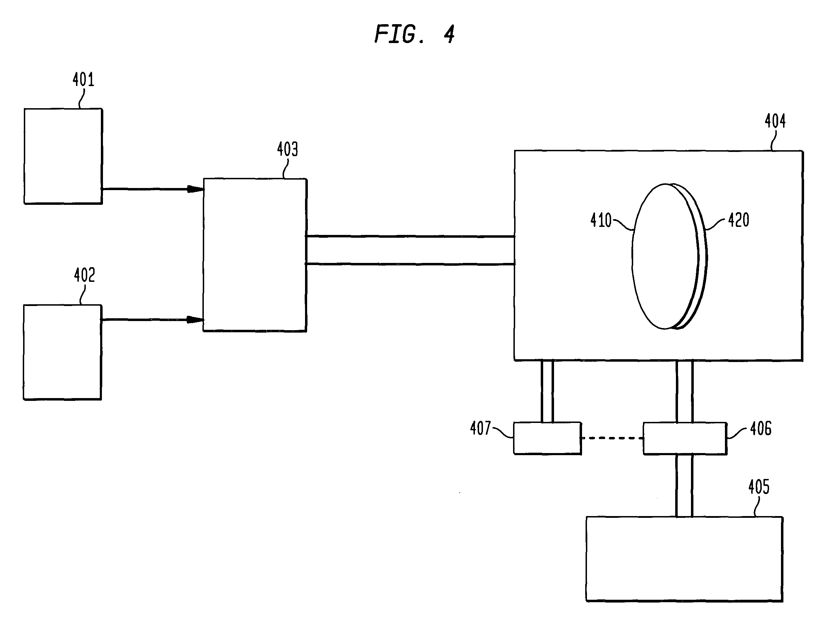

Figure 4 shows a system for carrying out high rate wafer etching. In greater detail, the system shown in Figure 4 includes an argon source 401, a F2 source 402, and an RPS 403, connected to the process chamber 404 that is controlled using a vacuum pump 405, valve 406 and pressure transducer 407. One method for operation of the system shown in Figure 4 is as follows:

Initially, the RPS 403 is set at approximately 0.5-3 Torr on transducer 407 which controls valve 406 on vacuum pump 405 with an argon flow of 1-2 slpm from argon source 401.

The plasma is then initiated by RPS 403 using pure argon.

F2 from F2 source 402 is then introduced and slowly ramped up from no flow at a rate no greater than 1 slpm increase per 5 seconds (i.e. ramping to 2 slpm should take at least 10 seconds). This helps the plasma stay lit while the fluorine is being added.

Argon flow rate is then increased to 10-20 slpm or between 3 times and 10 times the ultimate F2 flow for the particular process.

The pressure of process chamber 404 is increased to between 30 and 300 Torr while maintaining plasma, using transducer 407 to control valve 406 on vacuum pump 405 during or after the ramp up of argon flow.

F2 flow is increased up to the full flow rate based on the size of the process chamber 404, e.g. from 2-200 slpm.

The argon flow is maintained at 3 to 10 times the F2 flow rate.

By using the above sequence, a silicon wafer 410 supported on a temperature controlled heater/cooler 420, in process chamber 404 will be etched or thinned until the desired thickness or layer removal is achieved. At the end of the cycle, the F2 flow is turned off, then the plasma current on RPS 403 is turned off and finally, argon flow is turned down. The production process can then continue.

The present invention provides several advantages for a variety of processes and can be carried out in a variety of equipment. One advantage of the present invention is that existing hardware can be used in the sequences described above, but at higher cleaning or etch rates. This means that for deposition chamber cleaning, the clean period, which is a non-productive portion of the production cycle can be significantly reduced and therefore overall throughput of the equipment can be increased. Similarly, for wafer etch processes, the high etch rate accomplished by the present invention allows for an increase in the number of wafers per hour that can be processed and therefore a reduction in the overall cost processing and equipment.

### Experimental Data

### Experiment 1 - RPS Operating Limits

A vacuum system was assembled consisting of a NW40 4 way cross, the bottom of which was connected to a NW 100 spool piece packed with nickel, a vacuum control valve, a NW100 flexible spool piece and a BOCE Edwards QDP 80/500 dry pump. Connected to the left inlet of the 4 way cross was the outlet of an MKS Astronex remote plasma source. On the inlet side of the Astronex was an MFC controlled source of Ar and either NF3 or F2. Installed on top of the 4 way cross was a pressure transducer and on the left hand side a viewport.

A controlled flow of Ar was established and the plasma ignited. A set flow rate of source gas (NF3 or F2) was established and the Ar flow discontinued. The pressure in the system was set with the vacuum control valve from base to some maximum value. At regular intervals and at planned pressures the power drawn from the RPS (kW) was measured and recorded with a Fluke Model 41 B power analyzer. When pressures caused the maximum power of the RPS (10 kw) to be exceeded, the plasma was extinguished. This process was repeated for several flow rates and data was collected.

The RPS operating window (pressure, flow) for F2 was found to be much wider than that of NF3. The RPS specified power draw limit of 8 kW was not breached for F2 up to 18 slm and 100 Torr, wherein the limit is reached when using NF3 at 6 slm and 17.5 Torr. While this data for F2 represents higher pressure and flow conditions than current chamber clean practice, the wide parameters were investigated for their effect on cleaning and etch rate as further discussed below.

### Experiment 2 - Etch Rate Comparisons

The apparatus described in Experiment 1 was used, except that the 4 way cross was replaced with a 6 way cross. A removable, water-cooled, wafer chuck was installed on one port. The chuck was designed to hold small samples of wafers coated with 2 um Si02. Installed in the opposite port was a viewport. A simple laser interferometer was directed through this port to measure the etch rate. Flows and pressure were manipulated as outlined below and etch rates were measured and recorded in the following manner. A laser of wavelength 670 nm strikes the Si02 layer and reflects off the top of the layer and the bottom. Depending upon the phase of the reflected light the two beams will either reinforce or cancel each other. As the etch process causes the Si02 layer to get thinner the signal from the detector will go through peaks and troughs. Measuring the time between peaks or troughs will give an etch rate in nm/s, with each wavelength representing a ~335 nm change in thickness. Results of this experiment are shown in the Table 1 above.

As noted above, this experiment shows that there is no statistically significant difference in the etch rates when using NF3 or F2 where stoichiometrically equivalent flow rates, similar system pressures and no Ar diluent are used.

### Experiment 3 - Optimization

During optimization etch rates were compared in relative terms. The etch rate corresponding to 100% was set as the slowest etch rate observed for all runs, which corresponds to standard run #2 for NF3 where pressure was set to 5.5 Torr and Ar / NF3 ratio to 3. The results of the optimization experiments are shown in Tables 3, 4 and 5.

**Table 3 -**

| NF3 Optimization | | | |
|---|---|---|---|
| **Standard Run** | **Ar/NF3 Ratio** | **Pressure (Torr)** | **Relative Etch Rate** **(% of run 2)** |
| 1 | 0 | 5.5 | 127.5 |
| 2 | 3 | 5.5 | 100 |
| 3 | 0 | 20 | 442.7 |
| 4 | 3 | 20 | 868.2 |
| 5 | 0 | 12.75 | 304.4 |
| 6 | 3 | 12.75 | 358.7 |
| 7 | 1.5 | 5.5 | 127 |
| 8 | 1.5 | 20 | 603.1 |
| 9 | 1.5 | 12.75 | 303.6 |
| 10 | 1.5 | 12.75 | 460.6 |
| 11 | 1.5 | 12.75 | 327.8 |
| 12 | 1.5 | 12.75 | 373.4 |
| 13 | 1.5 | 12.75 | 316.1 |

**Table 4 -**

| F2 Optimization | | | |
|---|---|---|---|
| **Standard Run** | **Ar/NF3 Ratio** | **Pressure (Torr)** | **Relative Etch Rate** **(% of run 2)** |
| 1 | 0 | 5 | 209.5 |
| 2 | 4 | 5 | 185.3 |
| 3 | 0 | 50 | 361.2 |
| 4 | 4 | 50 | 1264.3 |
| 5 | 0 | 27.5 | 361.2 |
| 6 | 4 | 27.5 | 528.4 |
| 7 | 2 | 5 | 169.4 |
| 8 | 2 | 50 | 863.4 |
| 9 | 2 | 27.5 | 459.7 |
| 10 | 2 | 27.5 | 459.7 |
| 11 | 2 | 27.5 | 680.8 |
| 12 | 2 | 27.5 | 737.5 |
| 13 | 2 | 27.5 | 643.6 |

**Table 5 -**

| Optimal Etch Rates | | | |
|---|---|---|---|
| **Source Gas** | **Ar/Source Gas Ratio** | **Pressure (Torr)** | **Relative Etch Rate** |
| NF3 (optimal) | 3 | 20 | 825 |
| NF3 (RPS limit) | 3 | 17.5 | 679 |
| F2 (optimal) | 4 | 50 | 1208 |

Two results for NF3 are shown in Table 5 because the optimal result for NF3 was obtained at a point where the RPS was operating beyond its specified limit. During optimization a statistical DOE process was followed. The system pressure and Ar diluent ratio at constant stoichiometrically equivalent flow rates were manipulated as seen in the Tables. The wide operating window for F2 was exploited so that the limits of the optimization variables were extended for F2 beyond those used for NF3. As can be seen in Table 4, optimal etch rates were found for both NF3 and F2 at relatively high pressures and high Ar diluent ratios. However, the optimal etch rate for F2 was at least 46% higher than that of NF3. At the specified limit of the RPS the optimal etch rate of F2 was at least 78% higher than that of NF3.

The above experiments were relatively narrow in scope. In other experiments noted above, pressures up to 170 Torr were shown to be possible for F2. It is believed that even higher pressures up to 300 Torr or more, may be possible and could increase etch rates even further. As noted above, the ratio of argon to F2 can be in the range of 3 to 1 up to 10 to 1. More preferably, a ratio of 4 to 1 up to 8 to 1 of Ar to F2 may be used. Higher ratios may also be possible and useful. The most preferred parameters are currently believed to be pressures greater than 20 Torr and ratios of Ar to F2 of more than 4 to 1.

The present invention provides for the use of F2 under high pressure and at high dilution with a gas such as Ar, for purposes of deposition chamber cleaning. In addition, the very high etch rates that can be achieved in accordance with the present invention may be used for surface etching operations.

It is anticipated that other embodiments and variations of the present invention will become readily apparent to the skilled artisan in the light of the foregoing description and examples, and it is intended that such embodiments and variations likewise be included within the scope of the invention as set out in the appended claims.

## Claims

1. A method for cleaning a deposition vacuum chamber, said method utilizing F2 plasma at a pressure greater than 20 Torr.

2. A method for etching a substrate in a vacuum chamber, said method utilizing F2 plasma at a pressure greater than 20 Torr.

3. A method according to Claim 1 or Claim 2, wherein said pressure is in the range from 20 Torr to 170 Torr.

4. A method according to any preceding claim, further utilizing a diluent gas selected from the group consisting of argon, nitrogen, helium and mixtures thereof.

5. A method according to Claim 4, wherein the ratio of diluent gas to F2 is in the range from 3:1 to 10:1, preferably in the range from 4:1 to 8:1.

6. A method of cleaning a deposition vacuum chamber; said method comprising the steps of:
providing an inert gas to a mixing area at a first flow rate;
initiating a plasma using said inert gas;
providing F2 gas at a first flow rate to said mixing area to create a mixed plasma;
increasing the flow rate of said inert gas to a second flow rate;
introducing said mixed plasma to said vacuum chamber;
increasing the pressure of said vacuum chamber while maintaining said mixed plasma;
increasing said flow rate of said F2 to a second flow rate while maintaining said flow rate of said inert gas at a rate between 3 and 10 times that of said second flow rate of said F2;
and cleaning said vacuum chamber.

7. A method of etching a substrate in a vacuum chamber; said method comprising the steps of:
providing an inert gas to a mixing area at a first flow rate;
initiating a plasma using said inert gas;
providing F2 gas at a first flow rate to said mixing area to create a mixed plasma;
increasing the flow rate of said inert gas to a second flow rate;
introducing said mixed plasma to said vacuum chamber;
increasing the pressure of said vacuum chamber while maintaining said mixed plasma;
increasing said flow rate of said F2 to as second flow rate while maintaining said flow rate of said inert gas at a rate between 3 and 10 times that of said second flow rate of said F2;
and etching said substrate.

8. A method according to Claim 6 or Claim 7, wherein said mixing area is a remote plasma source.

9. A method according to Claim 6 or Claim 7, wherein said mixing area is in said vacuum chamber.

10. A method according to any of Claims 6 to 9, wherein said inert gas is selected from the group consisting of argon, nitrogen, helium and mixtures thereof.

11. A method according to any of Claims 6 to 10, wherein said step of increasing said flow rate of said F2 comprising ramping up said flow rate at a rate no greater than 1 slpm per 5 seconds.

12. A method according to any of Claims 6 to 11, wherein said second flow rate of said F2 is in the range from 2 to 200 slpm.

13. A method according to any of Claims 6 to 12, wherein said inert gas flow is maintained at 4 to 8 times the F2 flow rate.

14. A method according to any of Claims 6 to 13, wherein said flow rate of said inert gas is in the range from 1 slpm to 20 slpm, preferably in the range of 1 slpm to 10 slpm, more preferably in the range of 2 slpm to 6 slpm.

15. A system for cleaning a deposition vacuum chamber, said system comprising:
a source of F2 gas;
a source of an inert gas; and
a mixing chamber connected to said source of F2 gas and to said source of inert gas for receiving the F2 gas and inert gas and outputting a gaseous mixture of said F2 gas and said inert gas to the vacuum chamber.

16. A system for etching a substrate in a vacuum chamber, said system comprising:
a source of F2 gas;
a source of an inert gas; and
a mixing chamber connected to said source of F2 gas and to said source of inert gas for receiving the F2 gas and inert gas and outputting a gaseous mixture of said F2 gas and said inert gas to the vacuum chamber.

17. A system according to Claim 15 or Claim 16, further comprising an inert gas inlet tube connected between said source of inert gas and said mixing chamber, said inert gas inlet tube being made from a material selected from the group consisting of nickel, Hastelloy, stainless steel, and combinations thereof.

18. A system according to Claim 17, wherein said inert gas inlet tube contains a packed bed of thermally conductive material selected from the group consisting of nickel, Hastelloy, stainless steel, copper, copper alloys, aluminium, aluminium alloys and combinations thereof.

19. A system according to Claim 17 or Claim 18, wherein said inert gas inlet tube has a diameter in the range from 1/2 inch to 2 inches, preferably in the range from 1/2 inch to 1 inch, more preferably around 3/4 inch.

20. A system according to any of Claims 17 to 19, comprising a heater communicating with said inert gas inlet tube, said heater being of a type selected from the group consisting of electrical resistance heaters, radiant heaters, gas fired combustion heaters, and combinations thereof.

21. A system according to any of Claims 15 to 20, comprising an F2 inlet tube connected between said source of F2 gas and said mixing chamber, said F2 inlet tube being made of a material selected from the group consisting of sapphire, dense aluminium oxide, nickel, Hastelloy, and combinations thereof.

22. A system according to Claim 21, wherein said F2 inlet tube has a diameter in the range from 1/4 inch to 3/4 inch, preferably in the range from 1/4 inch to 1/2 inch.
